**Europäisches Patentamt**

**European Patent Office**

**Office européen des brevets**

(19)

(11) Veröffentlichungsnummer: **0 131 148**
**A2**

(12) # EUROPÄISCHE PATENTANMELDUNG

(21) Anmeldenummer: **84106355.5**

(22) Anmeldetag: **04.06.84**

(51) Int. Cl.⁴: **G 06 F 13/00**

(30) Priorität: **13.06.83 DE 3321325**

(43) Veröffentlichungstag der Anmeldung:
**16.01.85 Patentblatt 85/3**

(84) Benannte Vertragsstaaten:
**AT CH DE FR GB IT LI**

(71) Anmelder: **Siemens Aktiengesellschaft**
**Berlin und München Wittelsbacherplatz 2**
**D-8000 München 2(DE)**

(72) Erfinder: **Schallenberger, Burghardt, Dr.**
**Brunnenweg 9a**
**D-8152 Feldolling(DE)**

(54) Kellerspeicher.

(57) In einem Kellerspeicher können z.B. Rücksprungadressen zwischengespeichert werden, wenn von einem Programm in ein Unterprogramm übergegangen wird. Diese Rücksprungadresse wird wieder in das Befehlsregister eines Prozessors übernommen, wenn zum Programm zurückgekehrt wird. Zur Adressierung der richtigen Rücksprungadresse ist im Kellerspeicher ein Stapelregister (PR) vorgesehen, das die Speicherzelle (SZ) im Kellerspeicher angibt, aus der die nächste auszuspeichernde Rücksprungadresse auszulesen ist bzw. in die die nächste einzuspeichernde Rücksprungadresse einzuschreiben ist. Dies wird dadurch erreicht, daß durch ein Zeigersignal vom Stapelregister (PR) eine erste Speicherzelle über erste Auswahltransistoren (AT1) mit ersten Bitleitungen (BL1) verbunden werden, die zum Datenausgangsbus (DA) führen und eine zweite benachbart zur ersten Speicherzelle angeordnete Speicherzelle über zweite Auswahltransistoren (AT2) mit zweiten Bitleitungen (BL2) verbunden werden, die zum Dateneingabebus (DE) führen. Dadurch werden mit einem einzigen Zeigersignal zwei benachbart angeordnete Speicherzellen angesteuert, von denen die eine beim Vorliegen eines Schreibbefehls, die andere beim Vorliegen eines Lesebefehls mit dem Dateneingabebus (DE) bzw. Datenausgabebus (DA) verbindbar ist. Mit dieser Maßnahme wird eine verringerung der Zugriffszeit zu dem Kellerspeicher erreicht.

FIG 1

EP 0 131 148 A2

**0131148**

SIEMENS AKTIENGESELLSCHAFT     Unser Zeichen
Berlin und München                VPA   **83 P 1 4 0 5 E**

Kellerspeicher

Die Erfindung bezieht sich auf einen Kellerspeicher mit Speicherzellen zur Aufnahme von z.B. Adressen, bei dem mit Hilfe eines Stapelzeigers festgelegt wird, in welche Speicherzelle eine Adresse einzuschreiben bzw. aus welcher Speicherzelle eine Adresse auszulesen ist.

Bei der Bearbeitung von Programmen in Datenverarbeitungssystemen treten häufig Sprünge von einem Hauptprogramm in ein Unterprogramm und von dort in weitere Unterprogramme auf. Bei einem solchen Sprung von einer höheren Programmebene in eine niedrigere Programmebene muß die Adresse des nächsten Befehls der höheren Programmebene in einem besonderen Register gespeichert werden. Nach der Bearbeitung des Unterprogramms muß dann wieder in die höhere Programmebene zurückgekehrt werden. Dazu muß die Adresse des nächsten Befehls (Rücksprungadresse) des Programms der höheren Programmebene von diesem Register, dem Kellerspeicher, in den Befehlszähler des Prozessors geladen werden. Bei diesem Verfahren muß gewährleistet sein, daß die jeweils zuletzt gespeicherte Adresse als jeweils nächste Rücksprungadresse aufgerufen wird.

Als Kellerspeicher kann ein RAM dienen, dessen Tiefe von der gewünschten Zahl der aufrufbaren verschiedenen Programmebenen abhängt. Dabei wählt ein Stapelzeiger immer die Adresse des Kellerspeichers aus, unter der z.B. gerade die letzte Rücksprungadresse festgehalten worden ist. Der Stapelzeiger kann z.B. ein Schieberegister (Stapelregister) sein, das mit einem Zeigersignal Wortleitungen des Kellerspeichers ansteuert. Bei Aufruf der Rücksprungadresse, wenn also von der niederen Programmebene in die nächst höhere Programmebene

Il 1 The - 8.6.1983

0131148

übergegangen werden soll, muß die im Kellerspeicher gespeicherte Rücksprungadresse ausgelesen werden. Dazu gibt das Stapelregister ein entsprechendes Zeigersignal ab, durch das die Speicherzelle des Kellerspeichers adressiert wird, in der die Rücksprungadresse enthalten ist. Anschließend wird das Zeigersignal im Stapelregister so verschoben, daß mit dem Zeigersignal die nächste Speicherzelle des Kellerspeichers ausgewählt wird, unter der die nächste infragekommende Rücksprungadresse gespeichert ist. Erfolgt nun während des Programmlaufs ein Sprungbefehl in eine untergeordnete Programmebene, muß also eine neue Rücksprungadresse in den Kellerspeicher geschrieben werden, dann muß das Zeigersignal im Stapelregister in umgekehrte Richtung verschoben werden, so daß die nächste unbesetzte Speicherzelle des Kellerspeichers adressiert wird. Dies ist erforderlich, bevor die nächste Rücksprungadresse in den Kellerspeicher eingespeichert werden kann. Um eine Rücksprungadresse im Kellerspeicher festzuhalten, ist also vor dem Einschreiben der Rücksprungadresse ein Verschieben des Zeigersignals im Stapelregister erforderlich. Die Funktion eines Kellerspeichers und die geschilderte Ansteuerung der Speicherzellen des Kellerspeichers ist bekannt und kann z.B. dem "Lexikon der Datenverarbeitung" des Verlages Moderne Industrie, München, 8. Auflage 1982 unter dem Stichwort "Kellerspeicher" entnommen werden.

Bei den bekannten Kellerspeichern ist somit die Zugriffszeit verhältnismäßig groß, da entweder vor der Durchführung eines Schreibbefehls, also einer Einspeicherung der neuen Rücksprungadresse in den Kellerspeicher, ein Verschieben des Zeigersignals im Stapelregister erforderlich ist oder beim Lesen einer Rücksprungadresse aus dem Kellerspeicher. Da nicht vorher bekannt ist, ob der nächste auszuführende Befehl ein Schreib- oder Lesefehler ist, muß bei Eintreffen eines Kellerspeicherbefehls in     50% der

0131148

VPA 83 P 1405 E

Fälle vor Ausführung des eigentlichen Speicherbefehls ein Verschieben des Zeigersignals im Stapelregister erfolgen.

Die der Erfindung zugrundeliegende Aufgabe besteht darin, einen Kellerspeicher derart aufzubauen, daß die Zugriffszeit zu den Speicherzellen sowohl beim Schreibefehl als auch beim Lesebefehl möglichst niedrig ist. Diese Aufgabe wird bei einem Kellerspeicher der eingangs angegebenen Art dadurch gelöst, daß der Stapelzeiger derart mit den Speicherzellen verbunden ist, daß durch ein vom Stapelzeiger abgegebenes Zeigersignal sowohl die Speicherzelle angesteuert wird, in die die nächste zu speichernde Adresse einzuschreiben ist als auch die Speicherzelle angesteuert wird, aus der die letzte eingespeicherte Adresse auszulesen ist.

Ein solcher Kellerspeicher kann in einfacher Weise realisiert werden, wenn jede Speicherzelle aus Speicherelementen besteht, von denen jedes jeweils über erste Auswahltransistoren mit ersten Bitleitungen und über zweite Auswahltransistoren mit zweiten Bitleitungen verbunden ist, wenn die ersten Bitleitungen zu einem Datenausgabebus, die zweiten Busleitungen zu einem Dateneingabebus führen, wenn der Stapelzeiger aus einem Register besteht, bei dem von jeder Stufe jeweils eine Ausgangsleitung für das Zeigersignal als Wortleitung zu den Speicherzellen führt, und wenn jeweils die Steuerelektroden der ersten Auswahltransistoren einer Speicherzelle und die Steuerelektroden der zweiten Auswahltransistoren einer benachbart angeordneten Speicherzelle mit derselben Wortleitung verbunden sind.

Andere Weiterbildungen der Erfindung ergeben sich aus den Unteransprüchen.

Der Vorteil der Erfindung besteht darin, daß durch ein Zeigersignal gleichzeitig eine Speicherzelle des Kellerspeichers in Lesebereitschaft und eine Speicherzelle des Kellerspeichers in Schreibbereitschaft gehalten wird. Damit ist bei Eintreffen eines Schreib- oder Lesebefehls nicht notwendig, daß das Zeigersignal im Stapelregister vorher verschoben werden muß. Erst nach Durchführung oder während der Durchführung eines Kellerspeicherbefehls wird das Zeigersignal im Stapelregister so verschoben, daß die Speicherzellen angesteuert werden, in die die nächste Rücksprungadresse einzuschreiben bzw. die nächste Rücksprungadresse auszulesen ist.

Anhand eines Ausführungsbeispiels, das in den Figuren dargestellt ist, wird die Erfindung weiter erläutert. Es zeigen

Fig. 1 ein Blockschaltbild des erfindungsgemäßen Kellerspeichers (beispielhaft für 2 Bit-Adressen und eine Tiefe von Drei),

Fig. 2 die Realisierung der Speicherelemente und einen möglichen Aufbau der Schaltkreise, über die die Speicherelemente mit dem Dateneingabebus bzw. Datenausgabebus verbunden sind,

Fig. 3 einen Aufbau eines Stapelregisters,

Fig. 4 einen anderen Aufbau eines Stapelregisters.

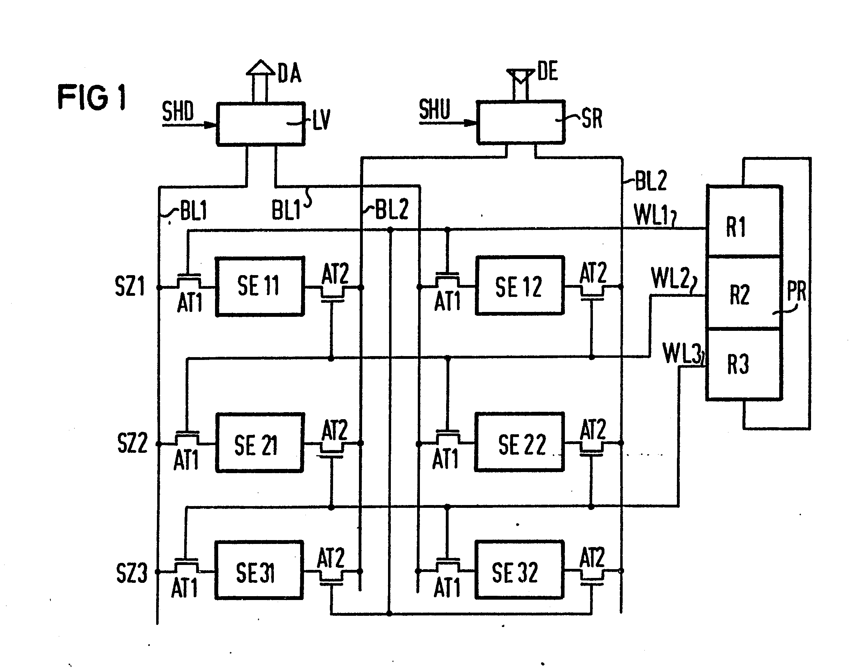

Der Kellerspeicher nach Fig. 1 besteht aus Speicherzellen SZ1, SZ2, SZ3, einem Stapelregister PR, einem Schaltkreis LV zur Übertragung von Adressen aus dem Kellerspeicher auf einen Datenausgabebus DA und einem Schaltkreis SR zur Übertragung von Adressen von einem Dateneingabebus DE in den Kellerspeicher.

Die Speicherzellen SZ bestehen aus Speicherelementen SE, wobei in jedes Speicherelement SE jeweils ein Bit einer Adresse gespeichert werden kann. In jeder Speicherzelle SZ wird somit eine Adresse gespeichert. Diese besteht im Ausführungsbeispiel der Fig. 1 jeweils aus zwei Bit. Beim Aufbau nach Fig. 1 können somit drei Adressen gespeichert werden.

Jedes Speicherelement SE jeder Speicherzelle SZ ist über einen ersten Auswahltransistor AT1 mit einer ersten Bitleitung BL1 und über einen zweiten Auswahltransistor AT2 mit einer zweiten Bitleitung BL2 verbunden. Die ersten Bitleitungen BL1 führen zu dem Schaltkreis LV und von dort zum Datenausgabebus DA. Die zweiten Bitleitungen BL2 führen zum Schaltkreis SR und von dort zum Dateneingabebus DE.

Durch Ansteuerung der ersten Auswahltransistoren AT1 können die Speicherelemente SE mit den ersten Bitleitungen BL1 und über den Schaltkreis LV mit dem Datenausgabebus DA verbunden werden. Entsprechend können durch Ansteuerung der Auswahltransistoren AT2 die Speicherelemente SE mit den zweiten Bitleitungen BL2 und über den Schaltkreis SR mit dem Dateneingabebus DE verbunden werden.

Die Ansteuerung der Auswahltransistoren AT erfolgt über Wortleitungen WL1, WL2, WL3. Diese Wortleitungen WL führen zum Stapelregister PR, und zwar ist der Ausgang jeder Registerstufe des Stapelregisters PR jeweils mit einer Wortleitung WL verbunden. Jede Wortleitung WL ist einerseits mit den ersten Auswahltransistoren AT1 einer Speicherzelle SZ und andererseits mit den zweiten Auswahltransistoren AT2 einer benachbart angeordneten Speicherzelle SZ verbunden. Zum Beispiel ist die Wortleitung WL2 mit den ersten Auswahltransistoren AT1 der Speicherelemente SE21, SE22 der Speicherzelle SZ2 verbunden und weiterhin an die zweiten Auswahltransistoren AT2 der Speicherelemente SE11, SE12 der Speicherzelle SZ1 angeschlossen. Durch ein Zeigersignal auf der Wortleitung WL2 werden somit die ersten Auswahltransistoren AT1 der Speicherzelle SZ2 leitend gesteuert und damit die entsprechenden Speicherelemente SE21, SE22 mit den ersten Bitleitungen BL1 verbunden. Gleichzeitig werden die zweiten Auswahltransistoren AT2 der Speicherzelle SZ1 mit den zweiten Bitleitungen BL2 verbunden.

Durch ein Zeigersignal auf der Wortleitung WL2 werden die Speicherzellen SZ1 und SZ2 so vorbereitet, daß in die Speicherzelle SZ1 eine Adresse eingeschrieben werden kann, während aus der Speicherzelle SZ2 eine Adresse ausgelesen werden kann. Ob in den Kellerspeicher eingeschrieben wird oder aus dem Kellerspeicher ausgelesen wird, wird dann durch ein Signal SHU bzw. SHD, das dem Schaltkreis  SR bzw. LV zugeführt wird, festgelegt.

In Figur 1 ist das Stapelregister PR als Ringschieberegister ausgeführt, dementsprechend muß auch die erste Speicherzelle SZ1 und die letzte Speicherzelle SZ3 des Kellerspeichers mit der Wortleitung WL1 verbunden sein. Die Wortleitung WL1 führt somit zu den ersten Auswahltransistoren AT1 der Speicherzelle SZ1 und zu den Auswahltransistoren AT2 der Speicherzelle SZ3. Bei einem derart ausgeführten Kellerspeicher werden        Adressen überschrieben, wenn die Anzahl von Programmsprüngen größer ist als die Tiefe des Kellerspeichers. Auf jeden Fall wird aber gewährleistet, daß die zuletzt in den Kellerspeicher gespeicherten Rücksprungadressen noch erreichbar sind.

Im folgenden soll kurz die Funktion des Kellerspeichers erläutert werden. Es sei angenommen, daß das Zeigersignal im Stapelregister PR in der Registerstufe R1 gespeichert ist. Dementsprechend wird die Wortleitung WL1 angesteuert und dadurch die Speicherelemente SE11, SE12 der Speicherzelle SZ1 mit den ersten Bitleitungen BL1 und die Speicherelemente SE31, SE32 der Speicherzelle SZ3 mit den zweiten Bitleitungen BL2 verbunden. Die Speicherzelle SZ3 ist somit für die Ausführung eines Schreibbefehls vorbereitet, die Speicherzelle SZ1 für die Ausführung eines Lesebefehls. Ob in den Kellerspeicher eingeschrieben oder aus dem Kellerspeicher ausgelesen wird, wird durch die Signale SHU bzw. SHD festgelegt.

Es sei angenommen, daß eine erste Adresse in den Kellerspeicher eingeschrieben werden soll, dies erfolgt dann in die Speicherzelle SZ3. Anschließend oder gleichzeitig mit dem Einschreibevorgang wird das Zeigersignal zur Registerstufe R3 verschoben. Damit werden die Speicherelemente der Speicherzelle SZ3 mit den ersten Bitleitungen BL1 und die Speicherzelle SZ2 mit den zweiten Bitleitungen BL2 verbunden. Somit kann nunmehr in die Speicherzelle SZ2 eine Adresse eingeschrieben werden oder aus der Speicherzelle SZ3 die Adresse ausgelesen werden. Durch Verschieben des Zeigersignals in die Registerstufe R2 wird die Wortleitung WL2 angesteuert, damit die Speicherzelle SZ1 mit den zweiten Bitleitungen BL2 und die Speicherzelle SZ2 mit den ersten Bitleitungen BL1 verbunden. Nunmehr kann eine Adresse in die erste Speicherzelle SZ1 eingeschrieben werden oder die Adresse aus der Speicherzelle SZ2 ausgelesen werden. Durch Verschieben des Zeigersignals von einer Registerstufe zur nächsten im Stapelregister PR wird somit immer eine Speicherzelle für den Schreibbefehl und eine Speicherzelle für den Lesebefehl vorbereitet.

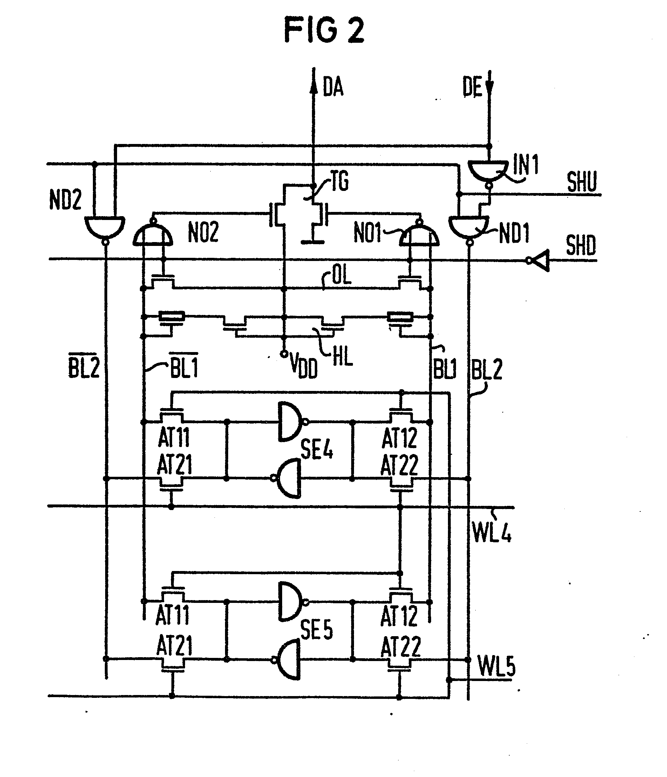

Figur 2 zeigt den Aufbau der Speicherelemente SE und eine Realisierungsmöglichkeit des Schaltkreises LV bzw. SR für den Fall, daß die Speicherzellen SZ aus einem Bit bestehen. Die Speicherelemente sind jetzt mit SE4 und SE5 bezeichnet. Sie sind in bekannter Weise in statischer MOS Technik aufgebaut. Jedes Speicherelement SE ist sowohl zwischen zwei ersten Bitleitungen BL1, $\overline{BL1}$ als auch zwischen zwei zweiten Bitleitungen BL2, $\overline{BL2}$ angeordnet. Dabei liegt auf der einen Bitleitung BL1 bzw. BL2 das Adressensignal in nicht invertierter Form, auf der anderen Bitleitung $\overline{BL1}$ bzw. $\overline{BL2}$ in invertierter Form vor. Dementsprechend ist auch jedes Speicherelement SE über jeweils zwei erste Auswahltransistoren AT11, AT12 mit den

ersten Bitleitungen $\overline{BL1}$,BL1 und jeweils über zwei zweite Auswahltransistoren AT21,AT22 mit den zweiten Bitleitungen $\overline{BL2}$,BL2 verbunden. Die Steuerelektroden der ersten Auswahltransistoren AT11, AT12 sind miteinander verbunden und führen zur selben Wortleitung WL4. Die Steuerelektroden der zweiten Auswahltransistoren AT21,AT22 sind ebenfalls miteinander verbunden und führen zur selben Wortleitung WL5.

Der Schaltkreis SR besteht aus einem ersten Inverterglied IN1 und zwei NAND-Gliedern ND1, ND2. Am Ausgang der NAND-Glieder ND1, ND2 sind die zweiten Bitleitungen BL2,$\overline{BL2}$ angeschlossen. Dem einen Eingang des NAND-Gliedes ND2 wird das einzuschreibende Adressensignal vom Dateneingangsbus DE zugeführt, dem anderen Eingang das Steuersignal SHU. Dem einen Eingang des NAND-Gliedes ND1 wird das Adressensignal durch das Inverterglied IN1 invertiert zugeführt, dem anderen Eingang das Steuersignal SHU. Mit Hilfe des Steuersignals SHU wird somit festgelegt, ob das Adressensignal auf dem Dateneingangsbus DE zu den zweiten Bitleitungen BL2, $\overline{BL2}$ gelangt oder nicht.

Der Schaltkreis LV besteht aus einer Halteschaltung HL, einer Vorladeschaltung OL, zwei NOR-Gliedern NO1,NO2 und einem Tristategatter TG. Der eine Eingang des NOR-Gliedes NO1 ist mit der Bitleitung BL1, der andere Eingang mit dem Steuersignal SHD verbunden. Entsprechend ist der eine Eingang des NOR-Gliedes NO2 mit der ersten Bitleitung $\overline{BL1}$ und mit dem Steuersignal SHD verbunden. Die Ausgänge der NOR-Glieder NO1 führen zum Tristategatter TG. Das Tristategatter TG ist mit dem Datenausgangsbus DA verbunden. Das Adressenbit auf den ersten Bitleitungen BL1 wird somit bei Vorliegen des Steuersignals SHD über die NOR-Glieder NO1, N0 dem Tristategatter TG zugeführt und gelangt von dort zum Datenausgangsbus DA.

0131148

Um ein unerwünschtes Floaten der Pegel auf den ersten Bitleitungen BL1,$\overline{BL1}$ zu verhindern, ist zwischen den ersten
Bitleitungen die Halteschaltung HL angeordnet. Zur Vorladung der ersten Bitleitungen BL1,$\overline{BL1}$ ist die Vorladeschaltung OL vorgesehen, durch die die ersten Bitleitungen in
etwa auf das Potential VDD umgeladen werden.

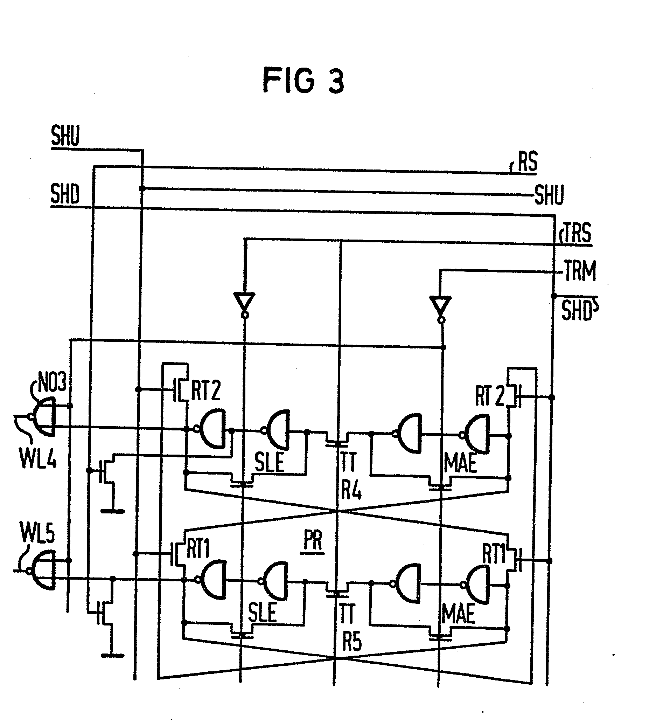

Eine Ausführung des Stapelregisters, wiederum ausgeführt
als Ringschieberegister, zeigt Figur 3. Jede Stufe $R4, R5$ des Stapelregisters PR ist aus jeweils zwei statischen Registerelementen MAE und SLE aufgebaut. Die Realisierung der Registerelemente MAE, SLE ist bekannt. Zwischen den Registerelementen MAE, SLE liegt jeweils ein Transfertransistor TT. Der Ausgang des Registerelements SLE führt jeweils zu einer Wortleitung WL. Der Ausgang einer Registerstufe ist jeweils
über einen ersten Richtungstransistor RT1 mit einer der zwei
benachbart liegenden Registerstufen verbunden und über den
Richtungstransistor RT2 mit der anderen der benachbart liegenden Registerstufen verbunden. Mit den Richtungstransistoren RT1, RT2 wird somit festgelegt, in welcher Richtung
das Zeigersignal durch das Stapelregister hindurchgeschoben
wird. Im Ausführungsbeispiel der Figur 3, in dem das Stapelregister PR lediglich aus zwei Stufen besteht, ist es an
sich nicht notwendig, daß jeweils zwei Richtungstransistoren
RT vorgesehen sind.

Zu Beginn des Betriebes wird durch ein Reset-Signal RS das
Stapelregister PR derart eingestellt, daß das Zeigersignal
am Ausgang des Registerelements SLE der Registerstufe $R4$
erscheint. Dieses Zeigersignal wird über das NOR-Glied NO3
auf die Wortleitung WL4 übertragen, wenn ein Steuersignal
TRM anliegt. Soll in den Kellerspeicher eine Adresse eingeschrieben werden, dann wird das Steuersignal SHU angelegt
und die am Dateneingangsbus DE anliegende Information in
das Speicherelement SE4 eingeschrieben. Gleichzeitig wird der Richtungstransistor RT2 angesteuert und damit die Richtung festgelegt, in welcher das Zeigersignal im Stapelregister PR verschoben wird. Das Zeigersignal wird damit über den Richtungstransistor RT2 in das Registerelement MAE der Registerstufe R5 übernommen. Dies geschieht noch zu einem Zeitpunkt, zu dem das Zeigersignal an der Wortleitung WL4 anliegt. Um zu verhindern, daß am Ausgang der Registerstufe R5 bereits jetzt das Zeigersignal erscheinen kann, wird der Transfertransistor TT zwischen den Registerelementen MAE und SLE gesperrt und dadurch die Übertragung des Zeigersignals von dem Registerelement MAE zum Registerelement SLE der Registerstufe R5 verhindert. Erst wenn das Zeigersignal von der Wortleitung WL4 abgeschaltet wird, wird die Verbindung zwischen den Registerelementen MAE und SLE der Registerstufe R5 durch ein Steuersignal TRS hergestellt und damit das Zeigersignal zum Registerelement SLE der Registerstufe R5 übertragen. Nunmehr kann das Zeigersignal der Wortleitung WL5 zugeführt werden. Die Funktion des Stapelregister PR beim Lesen erfolgt in entsprechender Weise. Mit Hilfe des Steuersignals SHD wird jetzt jedoch der Richtungstransistor RT1 leitend gesteuert.

Das Stapelregister PR ist somit so ausgeführt, daß das Verschieben des Zeigersignals von einer Registerstufe zur benachbarten Registerstufe bereits erfolgt, während in ein Speicherelement SE entweder ein Adressensignal eingeschrieben wird oder aus dem Speicherelement ein Adressensignal ausgelesen wird. Das Steuersignal TRM und das Steuersignal TRS wird dazu verwendet, um die statischen Registerelemente MAE und SLE auf bekannte Weise zu betreiben.

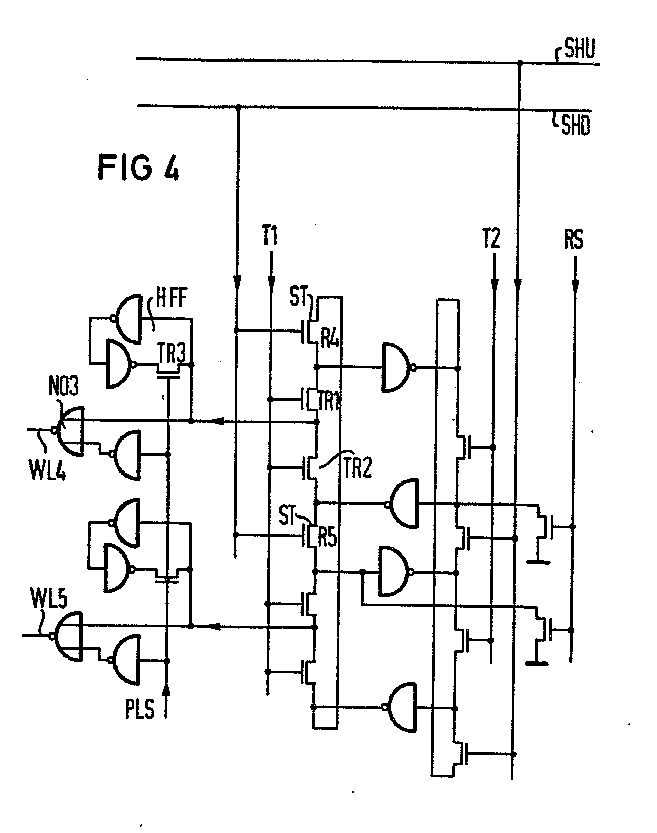

Das Stapelregister nach Fig. 4 besteht aus Registerzellen R4 R5, die in dynamischer MOS-Technik realisiert sind. Das Stapelregister ist als Ringschieberegister ausgebildet und kann in Vorwärts- und Rückwärtsrichtung betrieben wer-

0131148

den. Die Besonderheit dieses Stapelregisters besteht darin, daß jede Registerzelle R4, R5 statt des üblichen Transfertransistors ST und Transfertransistors TR1 noch einen weiteren Transfertransistor TR2 aufweist. Beide Transfertransistoren TR1, TR2 werden vom Steuersignal T1 angesteuert. Dadurch ist es möglich, die Wortleitungen WL4, WL5 von der Registerzelle abzukoppeln. Um die auf der Wortleitung WL4, WL5 liegende Information für diesen Fall zu erhalten, ist ein Halteflipflop HFF an die Wortleitung angeschlossen. Im Rückkopplungszweig des Halteflipflops HFF ist ein Transistor TR3 angeordnet, der mit Hilfe eines Steuersignals PLS ein- oder ausgeschaltet werden kann.

Durch diese besondere Abkopplungsmöglichkeit der Wortleitung kann noch während des Einschreibens oder Auslesens einer Adresse in/aus dem Kellerspeicher mit dem Verschiebevorgang des Zeigersignals im Stapelregister begonnen werden. Während des Beginns dieses Verschiebevorgangs wird das Signal auf der Wortleitung durch das zugeordnete Halteflipflop HFF stabilisiert, so daß die Auswahltransistoren AT der Speicherzellen sicher angesteuert werden.

11 Patentansprüche
4 Figuren

Patentansprüche

1. Kellerspeicher mit Speicherelementen zur Aufnahme von z.B. Adressen, bei dem mit Hilfe eines Stapelzeigers festgelegt wird, in welche Speicherzelle eine Adresse einzuschreiben bzw. aus welcher Speicherzelle eine Adresse auszulesen ist, dadurch g e k e n n z e i c h n e t , daß der Stapelzeiger (PR) derart mit den Speicherzellen (SZ) verbunden ist, daß durch ein vom Stapelzeiger abgegebenes Zeigersignal sowohl die Speicherzelle angesteuert wird, in die die nächste zu speichernde Adresse einzuschreiben ist als auch die Speicherzelle angesteuert wird, in der die letzte eingespeicherte Adresse enthalten ist.

2. Kellerspeicher nach Anspruch 1, dadurch g e - k e n n z e i c h n e t , daß jede Speicherzelle (SZ) aus Speicherelementen (SE) besteht, von denen jedes über erste Auswahltransistoren (AT1) mit ersten Bitleitungen (BL1) und über zweite Auswahltransistoren (AT2) mit zweiten Bitleitungen (BL2) verbunden ist, daß die ersten Bitleitungen (BL1) zu einem Datenausgabebus (DA), die zweiten Bitleitungen (BL2) zu einem Dateneingabebus (DE) führen, daß der Stapelzeiger (PR) aus einem Stapelregister besteht, bei dem von jeder Registerstufe (R) jeweils eine Ausgangsleitung für das Zeigersignal als Wortleitung (WL) zu einer zugeordneten Speicherzelle (SZ) führt, und daß jeweils die Steuerelektrode der ersten Auswahltransistoren (AT1) einer Speicherzelle und die Steuerelektroden der zweiten Auswahltransistoren (AT2) einer benachbart angeordneten Speicherzelle mit derselben Wortleitung verbunden sind.

3. Kellerspeicher nach Anspruch 2, dadurch g e - k e n n z e i c h n e t , daß das Stapelzeigerregister (PR) aus einem rückgekoppelten Schieberegister besteht, das in Vorwärts- und Rückwärtsrichtung betreibbar ist.

4. Kellerspeicher nach Anspruch 3, dadurch g e -
k e n n z e i c h n e t , daß die Steuerelektroden der
ersten Auswahltransistoren (AT1) der ersten Speicherzelle
(SZ1) und die Steuerelektroden der zweiten Auswahltransistoren (AT2) der letzten Speicherzelle (SZ3) miteinander
verbunden sind und an dieselbe Registerstufe (R1) angeschlossen sind.

5. Kellerspeicher nach einem der Ansprüche 2 bis 4, dadurch
g e k e n n z e i c h n e t , daß jedes Speicherelement
aus statischen MOS Speicherelementen besteht, deren einer
Ein/Ausgang über jeweils einen ersten Auswahltransistor (AT12)
mit einer ersten Bitleitung (BL1) und deren anderer Ein/
Ausgang über jeweils einen anderen ersten Auswahltransistor (AT11) mit einer anderen ersten Bitleitung ($\overline{BL1}$) verbunden ist, und daß die eine erste Bitleitung (BL1) und
die andere erste Bitleitung ($\overline{BL1}$) über einen von einem Steuersignal (SHD) angesteuerten Schaltkreis (LV) mit dem Datenausgabebus (DA) verbunden ist.

6. Kellerspeicher nach einem der Ansprüche 2 bis 4, dadurch
g e k e n n z e i c h n e t , daß jedes Speicherelement
aus statischen MOS Speicherelementen besteht, deren einer
Ein/Ausgang über jeweils einen zweiten Auswahltransistor
(AT22) mit jeweils einer zweiten Bitleitung (BL2) verbunden
ist und deren anderer Ein/Ausgang über jeweils einen anderen zweiten Auswahltransistor (AT21) mit einer anderen zweiten Bitleitung ($\overline{BL2}$) verbunden ist, und daß die eine zweite
Bitleitung und die andere zweite Bitleitung über einen von
einem Steuersignal (SHU) angesteuerten Schaltkreis (SR) mit
dem Dateneingabebus (DE) verbunden ist.

7. Kellerspeicher nach Anspruch 5, dadurch g e -
k e n n z e i c h n e t , daß zwischen der einen und der
anderen ersten Bitleitung (BL1,$\overline{BL1}$) eine Halteschaltung (HL) angeordnet ist, die ein Floaten des Potentials auf den
ersten Bitleitungen verhindert.

8. Kellerspeicher nach Anspruch 5 oder 7, dadurch  g e -
k e n n z e i c h n e t  , daß die eine und die andere
erste Bitleitung (BL1,$\overline{BL1}$) über ein von dem Steuersignal
(SHD) angesteuertes NOR-Glied (NO1,NO2) mit einem Tristategatter (TG) verbunden ist.

9. Kellerspeicher nach einem der Ansprüche 2 bis 8, dadurch
g e k e n n z e i c h n e t  , daß jede Registerstufe (R1)
des Stapelregisters (PR) aus zwei hintereinander angeordneten über einen Transfertransistor (TT) miteinander verbundenen statischen Registerelementen (MAE, SLE) besteht, deren
Ausgang mit einer Wortleitung (WL) und zur Festlegung der
Schieberichtung über einen ersten Richtungstransistor (RT1,
RT2) mit dem Eingang der einen benachbart angeordneten Registerstufe und über einen zweiten Richtungstransistor (RT2)
mit dem Eingang der anderen benachbart angeordneten Registerstufe verbunden ist.

10. Kellerspeicher nach einem der Ansprüche 2 bis 8,
dadurch  g e k e n n z e i c h n e t  , daß jede Registerstufe des Stapelregisters einen ersten von einem ersten
Steuersignal (SHD) angesteuerten Transfertransistor und
zwei von einem zweiten Steuersignal (T1) angesteuerte Transfertransistoren (TR1, TR2) enthält, deren gesteuerte Strekken in Serie liegen, und daß die Leitung für das Zeigersignal am Verbindungspunkt der gesteuerten Strecken der
zwei Transfertransistoren angeschlossen ist.

. Kellerspeicher nach Anspruch 10, dadurch  g e -
k e n n z e i c h n e t  , daß an der Leitung für das
Zeigersignal jeder Registerstufe ein Halteflipflop (HFF)
angeschlossen ist, das den Wert des Zeigersignals
speichert.

FIG 1

1/4

0131148

# FIG 2

FIG 3

3/4

0131148

FIG 4